# EUROPEAN PATENT SPECIFICATION

(11) **EP 4 300 567 B1**
(45) Date of publication and mention of the grant of the patent: **04.11.2026**
(21) Application number: 23179942.0
(22) Date of filing: 19.06.2023
(51) Int. Cl.: H10W 70/60, H10W 90/00

(54) **PACKAGE-ON-PACKAGE HAVING A THICK LOGIC DIE**
PACKAGE-ON-PACKAGE MIT EINEM DICKEN LOGISCHEN CHIP
BOÎTIER SUR BOÎTIER AYANT UNE PUCE LOGIQUE ÉPAISSE

(30) Priority: 22.06.2022 US 202263354361 P; 22.06.2022 US 202263354363 P; 09.02.2023 US 202318107520; 30.05.2023 US 202318203631
(43) Date of publication of application: 03.01.2024
(73) Proprietor: MediaTek Inc., Hsin-Chu 300 (TW)
(72) Inventor: YU, Ta-Jen, 30078 Hsinchu City (TW); TSAI, Wen-Chin, 30078 Hsinchu City (TW); SONG, Isabella, 30078 Hsinchu City (TW); CHEN, Tai-Yu, 30078 Hsinchu City (TW); KUO, Che-Hung, 30078 Hsinchu City (TW); LIU, Hsing-Chih, 30078 Hsinchu City (TW); LIN, Shih-Chin, 30078 Hsinchu City (TW); HSU, Wen-Sung, 30078 Hsinchu City (TW)
(74) Representative: Hoefer & Partner Patentanwälte mbB

(56) References cited:
- CN-A- 113 410 206
- US-A1- 2021 257 305

## Description

### Cross Reference to Related Application

This application is a continuation-in-part of U.S. Application No. 18/107,520, filed on February 9th, 2023, which claims the benefit of U.S. Provisional Application No. 63/316,004, filed on March 3rd, 2022. Further, this application claims the benefit of U.S. Provisional Application No. 63/354,361, filed on June 22nd, 2022. Further, this application claims the benefit of U.S. Provisional Application No. 63/354,363, filed on June 22nd, 2022.

### Background

The present disclosure generally relates to the field of semiconductor packaging. In particular, the present disclosure relates to a multi-chip module (MCM) package-on-package having a thick logic die. More particularly, the present invention relates to a package structure according to the pre-characterizing part of the independent claim. Such a package structure is shown in document CN 113410206 A.

Document US 2021/0257305 A1 discloses a package-on-package comprising a first package and a second package stacked on the first package.

Package-on-Package (PoP) is an integrated circuit packaging method to combine vertically discrete logic and memory ball grid array (BGA) packages. Two or more packages are installed atop each other, i.e. stacked, with a standard interface to route signals between them. This allows higher component density in devices, such as mobile phones or digital cameras.

PoP solutions are commonly used in baseband and applications processors in mobile phones. High-end phones have seen the fastest adoption of PoP packaging to provide high I/O and performance requirements. The main advantage of stacked PoP is that devices can be separately fully tested before assembly.

With development of the semiconductor industry, many studies are being conducted to improve reliability and durability of the semiconductor packages. An improvement of the PoP structure becomes very important and imperative.

### Summary

It is one object of the present disclosure to provide an improved package-on-package in order to solve the above-mentioned prior art deficiencies or shortcomings. This objective is achieved by a package structure according to the independent claim 1. The dependent claims define preferred embodiments thereof.

One aspect of the present disclosure provides a package-on-package, comprising a first package and a second package stacked on the first package. The first package comprises a bottom substrate and a top substrate space apart from the bottom substrate such that the bottom substrate and the top substrate define a gap therebetween; a logic die and at least one integrated circuit device mounted on a top surface of the bottom substrate in a side-by-side configuration, wherein the logic die has a thickness not less than 125 micrometer; a plurality of copper cored solder balls disposed between the bottom substrate and the top substrate around the logic die and the at least one integrated circuit device to electrically connect the bottom substrate with the top substrate; and a sealing resin filling in the gap between the bottom substrate and the top substrate and sealing the logic die, the at least one integrated circuit device, and the plurality of copper cored solder balls in the gap.

Preferably, the logic die comprises an application processor die or a SOC die.

Preferably, the logic die has a thickness of 125 -750 micrometers.

Preferably, the logic die is mounted on the top surface of the bottom substrate in a flip-chip fashion.

Preferably, the logic die comprises an active front side and a passive rear side, and wherein, a plurality of input/output (I/O) pads is provided on the active front side, and the logic die is electrically connected to the bottom substrate through a plurality of conductive elements formed on the plurality of I/O pads, respectively.

Preferably, each of the bottom substrate and the top substrate comprises a printed wiring board, an interposer substrate, a re-distribution layer (RDL) substrate, or a package substrate.

Preferably, the gap has a gap height not less than 160 micrometers.

Preferably, the gap has a gap height ranging between 160-1000 micrometers.

Preferably, an aspect ratio of the plurality of copper cored solder balls ranges between 1.1-2.0.

Preferably, a ball pitch of the plurality of copper cored solder balls is 0.2-0.3 mm.

Preferably, external connection terminals are disposed on a bottom surface of the bottom substrate.

Preferably, the second package is a memory package.

Preferably, the memory package comprises a LPDDR DRAM package.

Preferably, the at least one integrated circuit device comprise at least one of a modem, a memory known-good die, a power management IC, and an RF die.

Preferably, the logic die comprises an application processor die, and the at least one integrated circuit device comprises a modem die and a memory known-good die; and wherein the memory known-good die is stacked on the modem die, or the modem die and the memory known-good die are arranged in a side-by-side configuration.

Preferably, the logic die comprises an application processor die, and the at least one integrated circuit device comprises a modem die.

Preferably, the logic die comprises a SOC die, and the at least one integrated circuit device comprises a power management IC.

Preferably, the logic die comprises a SOC die, and the at least one integrated circuit device comprises an RF die.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the present disclosure and are incorporated in and constitute a part of this specification. The drawings illustrate embodiments of the present disclosure and, together with the description, serve to explain the principles of the present disclosure. In the drawings:
FIG. 1 is a schematic, cross-sectional diagram showing an exemplary semiconductor package having thick logic die in accordance with an embodiment of the present disclosure;
FIG. 2 is a schematic, cross-sectional diagram showing an exemplary package-on-package (PoP) having thick logic die in accordance with an embodiment of the present disclosure;
FIG. 3 is a schematic, cross-sectional diagram showing an exemplary package-on-package (PoP) having thick logic die in accordance with another embodiment of the present disclosure; and
FIG. 4 is a schematic, cross-sectional diagram showing an exemplary package-on-package (PoP) having thick logic die in accordance with still another embodiment of the present disclosure.

### Detailed Description

In the following detailed description of embodiments of the present disclosure, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the scope of the present disclosure. The following detailed description is, therefore, not to be taken in a limiting sense, and the scope of embodiments of the present disclosure is defined only by the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

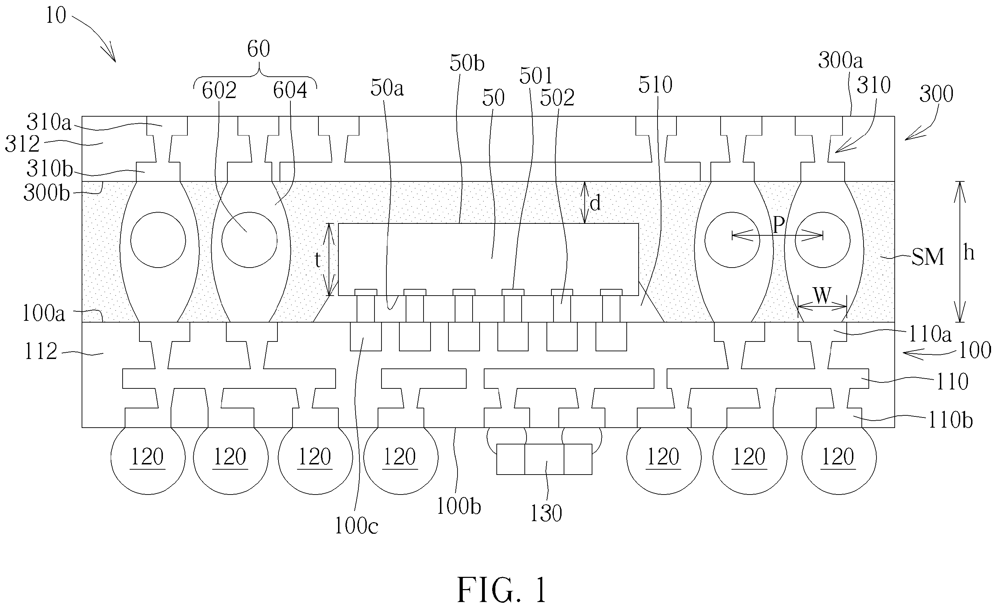

FIG. 1 is a schematic, cross-sectional diagram showing an exemplary semiconductor package having thick logic die in accordance with an embodiment of the present disclosure. As shown in FIG. 1, the semiconductor package 10 comprises a bottom substrate 100 having a top surface 100a and an opposing bottom surface 100b. Preferably, the bottom substrate 100 may be a printed wiring board or a package substrate having a plurality of conductive interconnect structures 110 and at least an insulating layer 112. Preferably, the conductive interconnect structures 110 may comprise a plurality of pad patterns 110a and 110c distributed on the top surface 100a and a plurality of pad patterns 110b distributed on the bottom surface 100b.

Preferably, a logic die 50 is mounted on the pad patterns 110c on the top surface 100a of the bottom substrate 100 in a flip-chip fashion. Preferably, the logic die 50 may be an application processor die or a baseband processor die, but is not limited thereto. Preferably, the logic die 50 has a thickness t ranging between 125-350 micrometers, for example, 170 micrometers, which is thicker than a normal logic die (has a thickness of about 80 micrometer) used in high-end mobile devices such as high-end mobile phones.

Preferably, the logic die 50 has an active front side 50a and a passive rear side 50b. Preferably, a plurality of input/output (I/O) pads 501 is provided on the active front side 50a. Preferably, the logic die 50 is electrically connected to the pad patterns 110c of the bottom substrate 100 through a plurality of conductive elements 502 such as solder bumps, metal bumps, micro-bumps, or pillars, which are formed on the plurality of I/O pads 501, respectively. Preferably, underfill resin 510 may be injected into a space between the logic die 50 and the top surface 100a of the bottom substrate 100. Preferably, the conductive elements 502 are surrounded by the underfill resin 510. Preferably, for example, the I/O pads 501 may be fanned out at the active front side 50a by using techniques known in the art, for example, a re-distribution layer (RDL) structure.

Preferably, the logic die 50 is disposed between the bottom substrate 100 and a top substrate 300. Preferably, the top substrate 300 may be a printed wiring board, an interposer substrate, or a package substrate having a plurality of conductive interconnect structures 310 and at least an insulating layer 312. Preferably, the conductive interconnect structures 310 may comprise a plurality of pad patterns 310a distributed on the top surface 300a and a plurality of pad patterns 310b distributed on the bottom surface 300b. Preferably, a plurality of copper cored solder balls 60 or other more ductility metal connection is disposed on the pad patterns 310b distributed on the bottom surface 300b of the top substrate 300, respectively.

Preferably, the bottom substrate 100 is connected electrically with the top substrate 300 via the copper cored solder balls 60 around the logic die 50. The sealing resin SM is filled into a gap having a gap height h between the bottom substrate 100 and the top substrate 300. Preferably, the gap height h may range between 160-450 micrometers in 0.2-0.3 mm ball pitch range, but is not limited thereto. Preferably, the pad patterns 110a, on which the copper cored solder balls 60 are attached, have a width w ranging between 100-300 micrometers, but is not limited thereto. Preferably, an aspect ratio of the copper cored solder ball 60 may range between 1.1-2.0, for example, 1.44. Preferably, a ball pitch P of the copper cored solder balls 60 may be 0.2-0.3 mm.

Preferably, the sealing resin SM surrounds the copper cored solder balls 60 and covers the passive rear side 50b and sidewalls of the logic die 50. Preferably, the sealing resin SM is in direct contact with the bottom surface 300b of the top substrate 300, the side surface of the underfill resin 510 and the top surface 100a of the bottom substrate 100. The gap between the bottom substrate 100 and the top substrate 300 is sealed with the sealing resin SM. The distance d between the passive rear side 50b of the logic die 50 and the bottom surface 300b of the top substrate 300 may be equal to or greater than 30 micrometers.

Preferably, each of the copper cored solder balls 60 may comprise a copper core 602 having a diameter of about 10 micrometers, which is coated with a solder layer 604. The copper cored solder balls 60 are joined to the bottom substrate 100 and the top substrate 300. Preferably, the copper core 602 is formed of copper or copper alloys and shaped into a solid sphere. Preferably, the top substrate 300 having the copper cored solder balls 60 may be mounted onto the top surface 100a of the bottom substrate 100 by using a thermal compression bonding (TCB) method.

Preferably, external connection terminals 120 such as solder balls or BGA balls are joined to the pad patterns 110b on the bottom surface 100b of the bottom substrate 100 for further connection with a mother board or a system board. Preferably, a surface mount device 130 such as a capacitor or a resistor may be mounted on the bottom surface 100b of the bottom substrate 100.

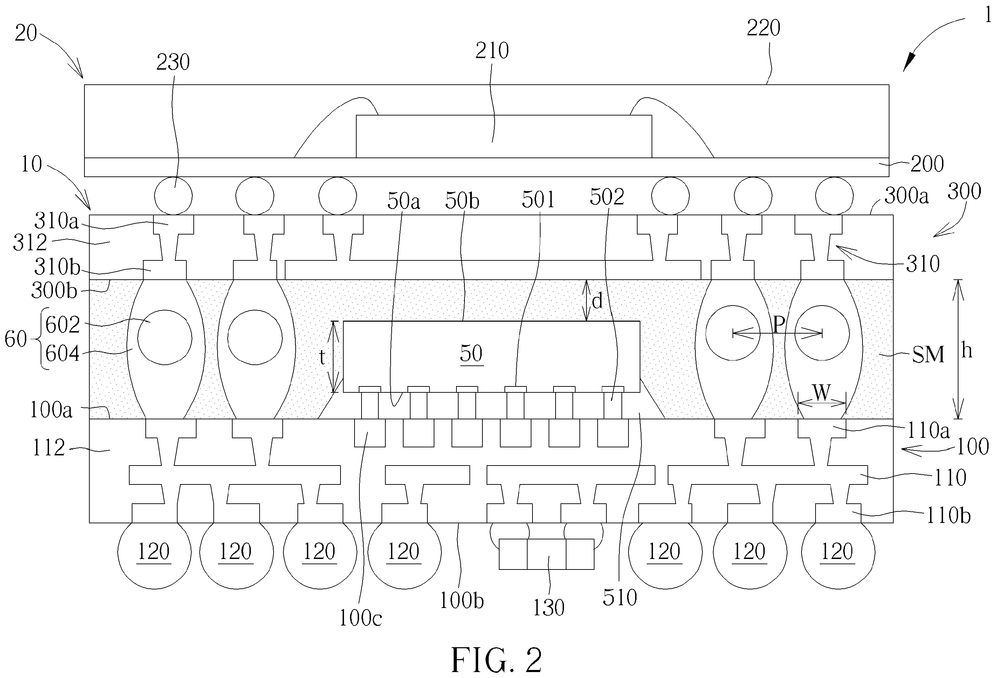

FIG. 2 is a schematic, cross-sectional diagram showing an exemplary package-on-package (PoP) having thick logic die in accordance with an embodiment of the present disclosure, wherein like layers, regions or elements are designated by like numeral numbers or labels. As shown in FIG. 2, the PoP 1 such as a high-bandwidth PoP (HBPoP) may comprise the semiconductor package 10 as set forth in FIG. 1 and a memory package 20 such as a LPDDR DRAM package stacked on the semiconductor package 10. Preferably, the memory package 20 may comprise a substrate 200, a memory die 210 mounted on the substrate 200, and a molding compound 220 encapsulating the memory die 210. Preferably, the memory package 20 may be electrically connected to the semiconductor package 10 through a plurality of conductive elements 230 such as solder balls or bumps.

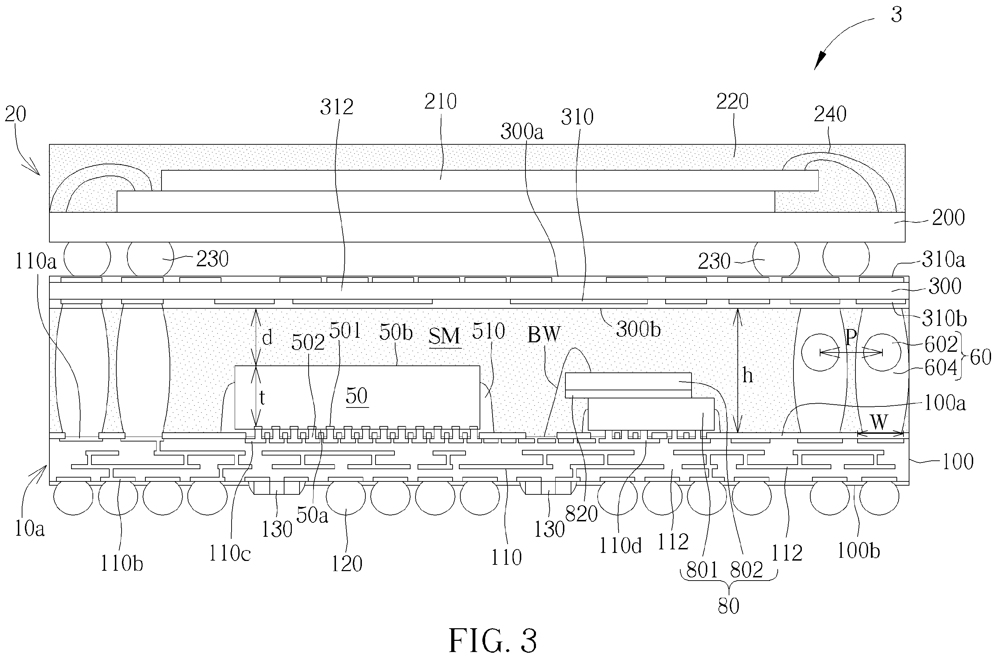

FIG. 3 is a schematic, cross-sectional diagram showing an exemplary package-on-package (PoP) having thick logic die in accordance with another embodiment of the present disclosure, wherein like layers, regions or elements are designated by like numeral numbers or labels. As shown in FIG. 3, the PoP 3 such as a high-bandwidth PoP (HBPoP) may comprise a semiconductor package 10a and a memory package 20 such as a LPDDR DRAM package stacked on the semiconductor package 10a. Preferably, the memory package 20 may comprise a substrate 200, a memory die 210 mounted on the substrate 200, and a molding compound 220 encapsulating the memory die 210. Preferably, the memory package 20 may be electrically connected to the semiconductor package 10a through the plurality of conductive elements 230 such as solder balls or bumps.

Preferably, likewise, the semiconductor package 10a comprises a bottom substrate 100 having a top surface 100a and an opposing bottom surface 100b. Preferably, the bottom substrate 100 may be a printed wiring board, an interposer substrate, a re-distribution layer (RDL) substrate, or a package substrate having a plurality of conductive interconnect structures 110 and at least an insulating layer 112. Preferably, the conductive interconnect structures 110 may comprise a plurality of pad patterns 110a, 110c, and 110d , and a plurality of pad patterns 110b, wherein the plurality of pad patterns 110a, 110c, and 110d are distributed on the top surface 100a, and the plurality of pad patterns 110b are distributed on the bottom surface 100b.

Preferably, a logic die 50 is mounted on the pad patterns 110c on the top surface 100a of the bottom substrate 100 in a flip-chip fashion. Preferably, the logic die 50 may be an application processor die, but is not limited thereto. Preferably, the logic die 50 has a thickness t, wherein t is not less than 125 micrometers, for example, t may be between 125-750 micrometers. Preferably, t is 170 micrometers, which is thicker than a normal logic die (has a thickness of about 80 micrometer) used in high-end mobile devices such as high-end mobile phones. Preferably, the logic die 50 has an active front side 50a and a passive rear side 50b. Preferably, a plurality of input/output (I/O) pads 501 is provided on the active front side 50a. Preferably, the logic die 50 is electrically connected to the pad patterns 110c of the bottom substrate 100 through a plurality of conductive elements 502 such as solder bumps, metal bumps, micro-bumps, or pillars, which are formed on the plurality of I/O pads 501, respectively. Preferably, underfill resin 510 may be injected into a space between the logic die 50 and the top surface 100a of the bottom substrate 100. Preferably, the conductive elements 502 are surrounded by the underfill resin 510.

Preferably, an integrated circuit device 80 is mounted in proximity to the logic die 50. Preferably, the integrated circuit device 80 and the logic die 50 are arranged in a side-by-side configuration. Preferably, the integrated circuit device 80 may comprise a modem die 801 and a memory known-good die 802 stacked on the modem die 801. Preferably, the modem die 801 is mounted on the pad patterns 110d of the bottom substrate 100 in a flip-chip fashion. The memory known-good die 802 may be mounted on the modem die 801 with an adhesive layer 820 and may be electrically connected to the bottom substrate 100 through a plurality of bond wires BW. Preferably, the integrated circuit device 80 may communicate with the logic die 50 through the bottom substrate 100.

It is advantageous to use this embodiment because the modem die 801 and the application processor 50 are mounted on the same bottom substrate 100, better communication between them can be achieved. Furthermore, in this embodiment, the logic die 50 is an application processor instead of SOC die, the cost can be benefits by increase of gross die per wafer and improved yield with smaller die.

Preferably, the logic die 50 and the integrated circuit device 80 are disposed between the bottom substrate 100 and a top substrate 300. Preferably, the top substrate 300 may be a printed wiring board, an interposer substrate, a re-distribution layer (RDL) substrate, or a package substrate having a plurality of conductive interconnect structures 310 and at least an insulating layer 312. Preferably, the conductive interconnect structures 310 may comprise a plurality of pad patterns 310a distributed on the top surface 300a and a plurality of pad patterns 310b distributed on the bottom surface 300b. Preferably, a plurality of copper cored solder balls 60 or other more ductility metal connection is disposed on the pad patterns 310b distributed on the bottom surface 300b of the top substrate 300, respectively.

Preferably, the bottom substrate 100 is connected electrically with the top substrate 300 via the copper cored solder balls 60 around the logic die 50 and the integrated circuit device 80. The sealing resin SM is filled into a gap having a gap height h between the bottom substrate 100 and the top substrate 300. Preferably, the gap height h is not less than 160 micrometers, for example, h may range between 160-1000 micrometers, but is not limited thereto. Preferably, the pad patterns 110a, on which the copper cored solder balls 60 are attached, have a width w ranging between 100-300 micrometers, but is not limited thereto. Preferably, an aspect ratio of the copper cored solder ball 60 may range between 1.1-2.0, for example, 1.44. Preferably, a ball pitch P of the copper cored solder balls 60 may be 0.2-0.3 mm.

Preferably, the sealing resin SM surrounds the copper cored solder balls 60 and covers the passive rear side 50b and sidewalls of the logic die 50 and the integrated circuit device 80. Preferably, the sealing resin SM is in direct contact with the bottom surface 300b of the top substrate 300, the side surface of the underfill resin 510 and the top surface 100a of the bottom substrate 100. The gap between the bottom substrate 100 and the top substrate 300 is sealed with the sealing resin SM. The distance d between the passive rear side 50b of the logic die 50 and the bottom surface 300b of the top substrate 300 may be equal to or greater than 30 micrometers.

Preferably, each of the copper cored solder balls 60 may comprise a copper core 602 having a diameter of about 10 micrometers, which is coated with a solder layer 604. The copper cored solder balls 60 are joined to the bottom substrate 100 and the top substrate 300. Preferably, the copper core 602 is formed of copper or copper alloys and shaped into a solid sphere. Preferably, the top substrate 300 having the copper cored solder balls 60 may be mounted onto the top surface 100a of the bottom substrate 100 by using a thermal compression bonding (TCB) method.

Preferably, likewise, external connection terminals 120 such as solder balls or BGA balls are joined to the pad patterns 110b on the bottom surface 100b of the bottom substrate 100 for further connection with a mother board or a system board. Preferably, a surface mount device 130 such as a capacitor or a resistor may be mounted on the bottom surface 100b of the bottom substrate 100.

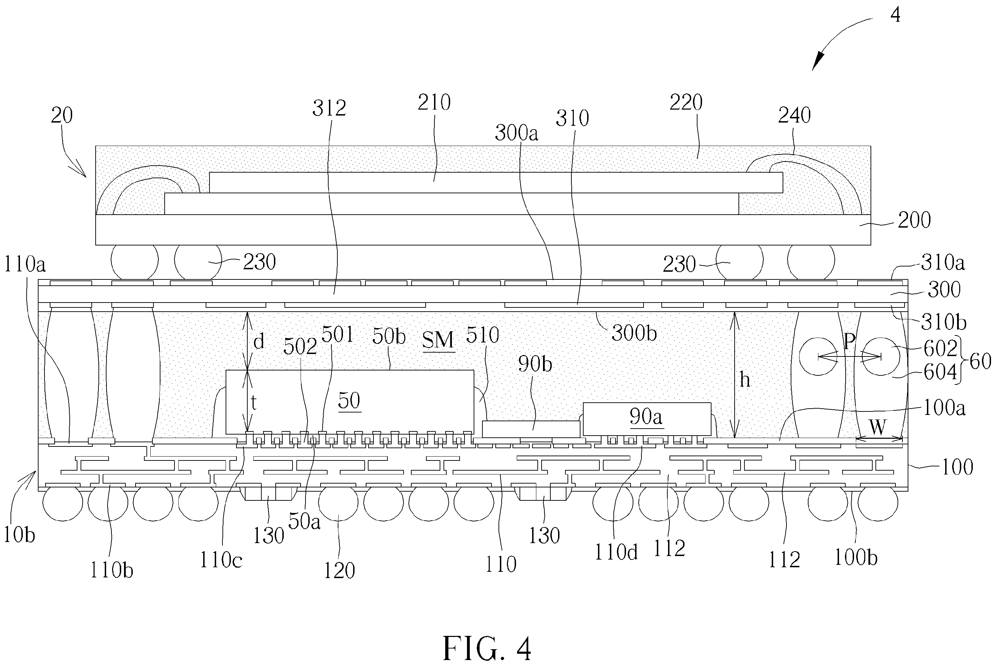

FIG. 4 is a schematic, cross-sectional diagram showing an exemplary package-on-package (PoP) having thick logic die in accordance with still another embodiment of the present disclosure, wherein like layers, regions or elements are designated by like numeral numbers or labels. As shown in FIG. 4, the PoP 4 such as a high-bandwidth PoP (HBPoP) may comprise the semiconductor package 10b and a memory package 20 such as a LPDDR DRAM package stacked on the semiconductor package 10b. Preferably, the memory package 20 may comprise a substrate 200, a memory die 210 mounted on the substrate 200, and a molding compound 220 encapsulating the memory die 210. Preferably, the memory package 20 may be electrically connected to the semiconductor package 10b through a plurality of conductive elements 230 such as solder balls or bumps.

Preferably, likewise, the semiconductor package 10b comprises a bottom substrate 100 having a top surface 100a and an opposing bottom surface 100b. Preferably, the bottom substrate 100 may be a printed wiring board, an interposer substrate, a re-distribution layer (RDL) substrate, or a package substrate having a plurality of conductive interconnect structures 110 and at least an insulating layer 112. Preferably, the conductive interconnect structures 110 may comprise a plurality of pad patterns 110a, 110c, and 110d distributed on the top surface 100a and a plurality of pad patterns 110b distributed on the bottom surface 100b.

Preferably, a logic die 50 is mounted on the pad patterns 110c on the top surface 100a of the bottom substrate 100 in a flip-chip fashion. Preferably, the logic die 50 may be an application processor die or a SOC die (usually integrates an application processor and a modem), but is not limited thereto. Preferably, the logic die 50 has a thickness t, wherein t is not less than 125 micrometers, for example, t is between 125-750 micrometers. Preferably, t is 170 micrometers, which is thicker than a normal logic die (has a thickness of about 80 micrometer) used in high-end mobile devices such as high-end mobile phones. Preferably, the logic die 50 has an active front side 50a and a passive rear side 50b. Preferably, a plurality of input/output (I/O) pads 501 is provided on the active front side 50a. Preferably, the logic die 50 is electrically connected to the pad patterns 110c of the bottom substrate 100 through a plurality of conductive elements 502 such as solder bumps, metal bumps, micro-bumps, or pillars, which are formed on the plurality of I/O pads 501, respectively. Preferably, underfill resin 510 may be injected into a space between the logic die 50 and the top surface 100a of the bottom substrate 100. Preferably, the conductive elements 502 are surrounded by the underfill resin 510.

Preferably, at least one integrated circuit device may be mounted in proximity to the logic die 50 on the top surface 100a of the bottom substrate 100. The at least one integrated circuit device and the logic die 50 are arranged in a side-by-side configuration. For example, but not limited to, the at least one integrated circuit device may comprise at least one of a modem, a memory known-good die, a power management IC, and an RF die. Preferably, multiple integrated circuit devices 90a and 90b may be mounted in proximity to the logic die 50 on the top surface 100a of the bottom substrate 100. Preferably, wherein the logic die 50 may be an application processor die, and the integrated circuit devices 90a and 90b may be a modem and a memory known-good die, respectively. According to another embodiment, an integrated circuit devices 90a may be mounted in proximity to the logic die 50 on the top surface 100a of the bottom substrate 100, wherein the logic die 50 may be an application processor die, and the integrated circuit device 90a may be a modem or a memory known-good die. According to another embodiment, an integrated circuit devices 90a may be mounted in proximity to the logic die 50 on the top surface 100a of the bottom substrate 100, wherein the logic die 50 may be a SOC die, and the integrated circuit device 90a may be a power management IC, an RF die. According to another embodiment, the integrated circuit devices 90a and 90b may be mounted in proximity to the logic die 50 on the top surface 100a of the bottom substrate 100, wherein the logic die 50 may be a SOC die, and the integrated circuit devices 90a and 90b may be a power management IC and an RF die, respectively.

Preferably, the integrated circuit devices 90a, 90b may be mounted on the pad patterns 110d of the bottom substrate 100 in a flip-chip fashion. Preferably, the integrated circuit devices 90a, 90b may communicate with the logic die 50 through the bottom substrate 100.

Preferably, the logic die 50 and the integrated circuit devices 90a, 90b are disposed between the bottom substrate 100 and a top substrate 300. Preferably, the top substrate 300 may be a printed wiring board, an interposer substrate, a re-distribution layer (RDL) substrate, or a package substrate having a plurality of conductive interconnect structures 310 and at least an insulating layer 312. Preferably, the conductive interconnect structures 310 may comprise a plurality of pad patterns 310a distributed on the top surface 300a and a plurality of pad patterns 310b distributed on the bottom surface 300b. Preferably, a plurality of copper cored solder balls 60 or other more ductility metal connection is disposed on the pad patterns 310b distributed on the bottom surface 300b of the top substrate 300, respectively.

Preferably, the bottom substrate 100 is connected electrically with the top substrate 300 via the copper cored solder balls 60 around the logic die 50 and the integrated circuit device 80. The sealing resin SM is filled into a gap having a gap height h between the bottom substrate 100 and the top substrate 300. Preferably, the gap height h may range between 160-1000 micrometers in 0.2-0.3 mm ball pitch range, but is not limited thereto. Preferably, the pad patterns 110a, on which the copper cored solder balls 60 are attached, have a width w ranging between 100-300 micrometers, but is not limited thereto. Preferably, an aspect ratio of the copper cored solder ball 60 may range between 1.1-2.0, for example, 1.44. Preferably, a ball pitch P of the copper cored solder balls 60 may be 0.2-0.3 mm.

Preferably, the sealing resin SM surrounds the copper cored solder balls 60 and covers the passive rear side 50b and sidewalls of the logic die 50 and the integrated circuit devices 90a, 90b. Preferably, the sealing resin SM is in direct contact with the bottom surface 300b of the top substrate 300, the side surface of the underfill resin 510 and the top surface 100a of the bottom substrate 100. The gap between the bottom substrate 100 and the top substrate 300 is sealed with the sealing resin SM. The distance d between the passive rear side 50b of the logic die 50 and the bottom surface 300b of the top substrate 300 may be equal to or greater than 30 micrometers.

Preferably, each of the copper cored solder balls 60 may comprise a copper core 602 having a diameter of about 10 micrometers, which is coated with a solder layer 604. The copper cored solder balls 60 are joined to the bottom substrate 100 and the top substrate 300. Preferably, the copper core 602 is formed of copper or copper alloys and shaped into a solid sphere. Preferably, the top substrate 300 having the copper cored solder balls 60 may be mounted onto the top surface 100a of the bottom substrate 100 by using a thermal compression bonding (TCB) method.

Preferably, likewise, external connection terminals 120 such as solder balls or BGA balls are joined to the pad patterns 110b on the bottom surface 100b of the bottom substrate 100 for further connection with a mother board or a system board. Preferably, a surface mount device 130 such as a capacitor or a resistor may be mounted on the bottom surface 100b of the bottom substrate 100.

## Claims

1. A package structure (3), comprising a first package (10), wherein the first package (10) comprises:
a bottom substrate (100) and a top substrate (300) space apart from the bottom substrate (100) such that the bottom substrate (100) and the top substrate (300) define a gap therebetween;
a logic die (50) and at least one integrated circuit device (80) mounted on a top surface (100a) of the bottom substrate (100) in a side-by-side configuration, wherein the logic die (50) has a thickness not less than 125 micrometer;
a plurality of copper cored solder balls (60) disposed between the bottom substrate (100) and the top substrate (300) around the logic die (50) and the at least one integrated circuit device (80) to electrically connect the bottom substrate (100) with the top substrate (300); and
a sealing resin (SM) filling in the gap between the bottom substrate (100) and the top substrate (300) and sealing the logic die (50), the at least one integrated circuit device (80), and the plurality of copper cored solder balls (60) in the gap;
**characterized in that** the package structure (3) is a package-on-package (3), and further comprises a second package (20) stacked on the first package (10);
wherein the logic die (50) comprises an application processor die, and the at least one integrated circuit device (80) comprises a modem die and a memory known-good die; and
wherein the memory known-good die is stacked on the modem die, or the modem die and the memory known-good die are arranged in a side-by-side configuration.

2. The package structure (3) according to claim 1, wherein the logic die (50) has a thickness of 125 -750 micrometers.

3. The package structure (3) according to claim 1 or 2, wherein the logic die (50) is mounted on the top surface (100a) of the bottom substrate (100) in a flip-chip fashion.

4. The package structure (3) according to claim 3, wherein the logic die (50) comprises an active front side (50a) and a passive rear side (50b), and wherein, a plurality of input/output, in the following also referred to as I/O, pads (501) is provided on the active front side (50a), and the logic die (50) is electrically connected to the bottom substrate (100) through a plurality of conductive elements (502) formed on the plurality of I/O pads (501), respectively.

5. The package structure (3) according to any one of claims 1 to 4, wherein each of the bottom substrate (100) and the top substrate (300) comprises a printed wiring board, an interposer substrate, a re-distribution layer, in the following also referred to as RDL, substrate, or a package substrate.

6. The package structure (3) according to any one of claims 1 to 5, wherein the gap has a gap height (h) not less than 160 micrometers; and/or
wherein the gap has a gap height (h) ranging between 160-1000 micrometers.

7. The package structure (3) according to any one of claims 1 to 6, wherein an aspect ratio of the plurality of copper cored solder balls (60) ranges between 1.1-2.0.

8. The package structure (3) according to any one of claims 1 to 7, wherein a ball pitch of the plurality of copper cored solder balls (60) is 0.2-0.3 mm.

9. The package structure (3) according to any one of claims 1 to 8, wherein external connection terminals (120) are disposed on a bottom surface (100b) of the bottom substrate (100).

10. The package structure (3) according to any one of claims 1 to 9, wherein the second package (20) is a memory package.

11. The package structure (3) according to claim 10, wherein the memory package comprises an LPDDR DRAM package.

## Patentansprüche

1. Gehäusestruktur (3), umfassend ein erstes Gehäuse (10), wobei das erste Gehäuse (10) Folgendes umfasst:
ein unteres Substrat (100) und ein oberes Substrat (300), das von dem unteren Substrat (100) beabstandet ist, so dass das untere Substrat (100) und das obere Substrat (300) einen Spalt dazwischen definieren;
einen Logikchip (50) und mindestens eine Integrierte-Schaltung-Vorrichtung (80), die auf einer oberen Oberfläche (100a) des unteren Substrats (100) in einer Seite-an-Seite-Konfiguration montiert sind, wobei der Logikchip (50) eine Dicke von nicht weniger als 125 Mikrometer aufweist;
mehrere Kupferkern-Lötkugeln (60), die zwischen dem unteren Substrat (100) und dem oberen Substrat (300) um den Logikchip (50) und die mindestens eine Integrierte-Schaltung-Vorrichtung (80) herum angeordnet sind, um das untere Substrat (100) mit dem oberen Substrat (300) elektrisch zu verbinden; und
ein Dichtungsharz (SM), das den Spalt zwischen dem unteren Substrat (100) und dem oberen Substrat (300) füllt und den Logikchip (50), die mindestens eine Integrierte-Schaltung-Vorrichtung (80) und die mehreren Kupferkern-Lötkugeln (60) in dem Spalt abdichtet;
**dadurch gekennzeichnet, dass** die Gehäusestruktur (3) ein Gehäuse-auf-Gehäuse (3) ist und ferner ein zweites Gehäuse (20) umfasst, das auf das erste Gehäuse (10) gestapelt ist;
wobei der Logikchip (50) einen Anwendungsprozessorchip umfasst und die mindestens eine Integrierte-Schaltung-Vorrichtung (80) einen Modemchip und einen Speicherchip mit nachgewiesener Funktionalität umfasst; und
wobei der Speicherchip mit nachgewiesener Funktionalität auf den Modemchip gestapelt ist oder der Modemchip und der Speicherchip mit nachgewiesener Funktionalität in einer Seite-an-Seite-Konfiguration angeordnet sind.

2. Gehäusestruktur (3) nach Anspruch 1, wobei der Logikchip (50) eine Dicke von 125 - 750 Mikrometer aufweist.

3. Gehäusestruktur (3) nach Anspruch 1 oder 2, wobei der Logikchip (50) auf der oberen Oberfläche (100a) des unteren Substrats (100) in einer Flip-Chip-Weise montiert ist.

4. Gehäusestruktur (3) nach Anspruch 3, wobei der Logikchip (50) eine aktive Vorderseite (50a) und eine passive Rückseite (50b) umfasst und wobei mehrere Eingangs-/Ausgangspads (501), im Folgenden auch als I/O-Pads bezeichnet, auf der aktiven Vorderseite (50a) bereitgestellt sind und der Logikchip (50) mit dem unteren Substrat (100) durch mehrere leitende Elemente (502), die jeweils auf den mehreren I/O-Pads (501) gebildet sind, elektrisch verbunden ist.

5. Gehäusestruktur (3) nach einem der Ansprüche 1 bis 4, wobei jedes des unteren Substrats (100) und des oberen Substrats (300) eine gedruckte Leiterplatte, ein Interposersubstrat, ein Umverteilungsschichtsubstrat, im Folgenden auch als RDL-Substrat bezeichnet, oder ein Gehäusesubstrat umfasst.

6. Gehäusestruktur (3) nach einem der Ansprüche 1 bis 5, wobei der Spalt eine Spalthöhe (h) von nicht weniger als 160 Mikrometer aufweist; und/oder
wobei der Spalt eine Spalthöhe (h) im Bereich zwischen 160 - 1000 Mikrometer aufweist.

7. Gehäusestruktur (3) nach einem der Ansprüche 1 bis 6, wobei ein Seitenverhältnis der mehreren Kupferkern-Lötkugeln (60) im Bereich zwischen 1,1 - 2,0 liegt.

8. Gehäusestruktur (3) nach einem der Ansprüche 1 bis 7, wobei ein Kugelabstand der mehreren Kupferkern-Lötkugeln (60) 0,2 - 0,3 mm beträgt.

9. Gehäusestruktur (3) nach einem der Ansprüche 1 bis 8, wobei externe Verbindungsanschlüsse (120) auf einer unteren Oberfläche (100b) des unteren Substrats (100) angeordnet sind.

10. Gehäusestruktur (3) nach einem der Ansprüche 1 bis 9, wobei das zweite Gehäuse (20) ein Speichergehäuse ist.

11. Gehäusestruktur (3) nach Anspruch 10, wobei das Speichergehäuse ein LPDDR-DRAM-Gehäuse umfasst.

## Revendications

1. Structure de boîtier (3), comprenant un premier boîtier (10), dans laquelle le premier boîtier (10) comprend :
un substrat inférieur (100) et un substrat supérieur (300) espacés du substrat inférieur (100) de sorte que le substrat inférieur (100) et le substrat supérieur (300) définissent un espace entre eux ;
une puce logique (50) et au moins un dispositif de circuit intégré (80) montés sur une surface supérieure (100a) du substrat inférieur (100) dans une configuration côte à côte, dans laquelle la puce logique (50) a une épaisseur non inférieure à 125 micromètres ;
une pluralité de billes de soudure fourrées de cuivre (60) disposées entre le substrat inférieur (100) et le substrat supérieur (300) autour de la puce logique (50) et de l'au moins un dispositif de circuit intégré (80) pour connecter électriquement le substrat inférieur (100) au substrat supérieur (300) ; et
une résine d'étanchéité (SM) remplissant l'espace entre le substrat inférieur (100) et le substrat supérieur (300) et scellant la puce logique (50), l'au moins un dispositif de circuit intégré (80), et la pluralité de billes de soudure fourrées de cuivre (60) dans l'espace ;
**caractérisée en ce que** la structure de boîtier (3) est un boîtier sur boîtier (3), et comprend en outre un second boîtier (20) empilé sur le premier boîtier (10) ;
dans laquelle la puce logique (50) comprend une puce de processeur d'application, et l'au moins un dispositif de circuit intégré (80) comprend une puce de modem et une puce mémoire testée et fonctionnelle ; et
dans laquelle la puce mémoire testée et fonctionnelle est empilée sur la puce de modem, ou la puce de modem et la puce mémoire testée et fonctionnelle sont agencées dans une configuration côte à côte.

2. Structure de boîtier (3) selon la revendication 1, dans laquelle la puce logique (50) a une épaisseur de 125 à 750 micromètres.

3. Structure de boîtier (3) selon la revendication 1 ou 2, dans laquelle la puce logique (50) est montée sur la surface supérieure (100a) du substrat inférieur (100) à la manière d'une puce retournée.

4. Structure de boîtier (3) selon la revendication 3, dans laquelle la puce logique (50) comprend un côté avant actif (50a) et un côté arrière passif (50b), et dans laquelle une pluralité de plages d'entrée/sortie, ci-après également appelées plages I/O, (501) est prévue sur le côté avant actif (50a), et la puce logique (50) est connectée électriquement au substrat inférieur (100) par l'intermédiaire d'une pluralité d'éléments conducteurs (502) formés sur la pluralité de plages I/O (501), respectivement.

5. Structure de boîtier (3) selon l'une quelconque des revendications 1 à 4, dans laquelle chacun du substrat inférieur (100) et du substrat supérieur (300) comprend une carte de câblage imprimé, un substrat d'interposeur, un substrat de couche de redistribution, ci-après également appelée couche RDL, ou un substrat de boîtier.

6. Structure de boîtier (3) selon l'une quelconque des revendications 1 à 5, dans laquelle l'espace a une hauteur d'espace (h) non inférieure à 160 micromètres ; et/ou
dans laquelle l'espace a une hauteur d'espace (h) comprise entre 160 et 1000 micromètres.

7. Structure de boîtier (3) selon l'une quelconque des revendications 1 à 6, dans laquelle un rapport d'aspect de la pluralité de billes de soudure fourrées de cuivre (60) est compris entre 1,1 et 2,0.

8. Structure de boîtier (3) selon l'une quelconque des revendications 1 à 7, dans laquelle un pas de bille de la pluralité de billes de soudure fourrées de cuivre (60) est de 0,2 à 0,3 mm.

9. Structure de boîtier (3) selon l'une quelconque des revendications 1 à 8, dans laquelle des bornes de connexion externes (120) sont disposées sur une surface inférieure (100b) du substrat inférieur (100).

10. Structure de boîtier (3) selon l'une quelconque des revendications 1 à 9, dans laquelle le second boîtier (20) est un boîtier de mémoire.

11. Structure de boîtier (3) selon la revendication 10, dans laquelle le boîtier de mémoire comprend un boîtier DRAM LPDDR.
